# EUROPÄISCHE PATENTSCHRIFT

(11) **EP 1 274 885 B1**
(45) Veröffentlichungstag und Bekanntmachung des Hinweises auf die Patenterteilung: **20.10.2004**
(21) Anmeldenummer: 01937971.8
(22) Anmeldetag: 30.03.2001
(51) Int. Cl.: C25D 17/06

(54) **ELEKTRISCHES KONTAKTIERELEMENT AUS ELASTISCHEM WERKSTOFF**
ELECTRICAL CONTACTING ELEMENT MADE OF AN ELASTIC MATERIAL
ELEMENT DE CONNEXION PAR CONTACT ELECTRIQUE A BASE DE MATERIAU ELASTIQUE

(30) Priorität: 20.04.2000 DE 10019720
(43) Veröffentlichungstag der Anmeldung: 15.01.2003
(73) Patentinhaber: ATOTECH Deutschland GmbH, 10553 Berlin (DE)
(72) Erfinder: HÜBEL, Egon, 90537 Feucht (DE)
(74) Vertreter: Effert, Bressel und Kollegen
(86) Internationale Anmeldenummer: PCT/DE2001/001355
(87) Internationale Veröffentlichungsnummer: WO 2001/081659

(56) Entgegenhaltungen:
- WO-A-00/11679
- WO-A-97/08366
- DE-A- 2 545 906
- SU-A- 1 650 790
- US-A- 1 773 042
- US-A- 4 100 054
- US-A- 4 155 815
- DATABASE WPI Section Ch, Week 197639 Derwent Publications Ltd., London, GB; Class A35, AN 1976-72972X XP002175714 & JP 51 091832 A (SONY CORP), 12. August 1976 (1976-08-12)

## Beschreibung

Die Erfindung betrifft eine Vorrichtung und ein Verfahren zum Kontaktieren von elektrolytisch zu behandelndem Gut, insbesondere Galvanisiergut, bei elektrolytischen Prozessen. Hierzu zählt unter anderem das elektrolytische Galvanisieren und das elektrolytische Ätzen von Leiterplatten.

Das elektrolytisch zu behandelnde Gut ist an der Oberfläche elektrisch leitfähig. Behandlungsgut, das im Inneren aus einem elektrisch nicht leitfähigen Werkstoff besteht, weist an der Oberfläche meist nur eine sehr dünne und gegen mechanische Belastungen hochempfindliche Metallschicht auf, die elektrolytisch behandelt wird. Diese Oberfläche wird beim Galvanisieren kathodisch gepolt, das heißt die Oberfläche ist mit dem Minuspol einer Gleichstromquelle verbunden. Die Gegenelektrode, in diesem Falle eine Anode, ist dementsprechend mit dem Pluspol elektrisch leitend verbunden. Beim elektrolytischen Ätzen sind die Polaritäten vertauscht. Das Behandlungsgut ist dann anodisch gepolt.

Strom wird dem Behandlungsgut auf verschiedene Art und Weise zugeführt. In US 4,155,815 A ist eine Durchlaufanlage zur Kontaktflächenmetallisierung von Leiterplatten beschrieben. Zur Durchführung des Verfahrens werden die Leiterplatten in der Anlage in senkrechter Lage befördert und hierzu von Transportorganen ergriffen, die gleichzeitig auch zur elektrischen Stromzuführung dienen. Die Transport-/Kontaktierelemente sind an umlaufenden Ketten befestigt und ergreifen die einlaufenden Leiterplatten. Die Kontaktierelemente bestehen aus Platten, die am unteren, den Leiterplatten zugewandten Enden elastische, ellektrisch leitfähige Kontaktbereiche aufweisen, die mit einer Metallplatte in elektrischem Kontakt stehen, um den Kontaktbereichen Strom zuführen zu können. Die Kontaktierelemente ergreifen die einlaufenden Leiterplatten an deren unterem Rand so, dass nur dieser Rand in die Metallisierflüssigkeit eintauchen kann und dass die Kontaktierflächen der Kontaktierelemente die zu metallisierenden Kontaktflächen auf den Leiterplatten elektrisch kontaktieren können.

In WO 0011679 A2 ist eine Vorrichtung zum elektrischen Kontaktieren von elektrolytisch zu behandelnden Gut in Horizontalanlagen offenbart. Die Vorrichtung umfasst Bügel einer Klammer als Kontaktträger mit Kontaktieretementen zur Stromzuführung. Die Kontaktierelemente weisen eine oder mehrere Kontaktflächen auf, welche vorzugsweise aus Titan hergestellt sind, wobei die Form der Kontaktflächen eine Beschädigung des Behandlungsgutes bei der Übertragung von großen Strömen vermeiden hilft. Bei Tauchbadanlagen wird zur Stromzuführung mit sogenannten Gestellen oder Drehstabgestellen gearbeitet. Meist federnde und elektrisch leitfähige Kontaktbügel, Klemmschrauben oder Drähte halten das Gut und dienen zugleich als Stromzuführung. Die Gestelle sind an das Behandlungsgut angepaßt.

Für die Befestigung von plattenförmigem Behandlungsgut an einem Warenträger werden auch Klammern verwendet. Insbesondere in der Leiterplattentechnik sind Klammern aus Metall weit verbreitet. Sie sind am Warenträger in einer Reihe im Abstand von einigen Zentimetern angeordnet. Die Klammern werden bei der Beschickung geöffnet. Durch eine Feder greifen und tragen sie die Platten während der naßchemischen Behandlung. Zugleich dienen die Klammern der Stromzuführung.

In Durchlaufanlagen, insbesondere in der Leiterplattentechnik, wird Strom unter anderem ebenfalls mittels Klammern in die Leiterplatten eingeleitet. Gleichzeitig dienen die Klammern dem Transport der Leiterplatten durch die Durchlaufanlage.

In DE 36 12 220 C2 ist eine Klammer zum klemmenden Erfassen von Platten oder plattenförmigen Teilen, beispielsweise Leiterplatten, für die galvanische Behandlung in Tauchbadanlagen beschrieben. Diese Klammer wird dort als Haltezange bezeichnet. Zur elektrischen Kontaktierung werden Klemmvorsprünge an der Haltezange auf der Oberfläche des Behandlungsgutes aufgesetzt.

In EP-A 0 254 962 ist unter anderem eine Klammer zur Halterung von Leiterplatten für die Behandlung in einer horizontalen Durchlaufanlage gezeigt. Auch in diesem Falle setzen Klemmbacken auf der Leiterplatte auf. Die Klemmbakken sind hier an den Kontaktflächen nicht spitz sondern flächig ausgebildet.

Ferner ist in DE-OS 25 45 906 eine Haltevorrichtung für zu beschichtende Teile in galvanischen Bädern offenbart. Die Vorrichtung umfaßt einen Metallrahmen sowie eine undurchlässige Umhüllung auf dem Rahmen, wobei mindestens ein Teil des Rahmens derart umhüllungsfrei ist, daß die Herstellung eines elektrischen Kontakts des von der Haltevorrichtung zu haltenden Teils mit einem Kontaktstück ermöglicht wird, das den umhüllungsfreien Teil umschließt. Das Kontaktstück ist aus einer nicht leitfähigen, federnd kompressiblen Trägermasse gebildet, die leitende Partikel enthält. Die Masse ist elektrisch nicht leitfähig, wenn sie nicht komprimiert wird. Elektrische Leitfähigkeit stellt sich nur dann ein, wenn das Material durch die Befestigung der zu behandelnden Teile komprimiert wird.

In DD-WP 71920 wird eine Aufhängevorrichtung für elektrolytisch zu behandelnde Werkstücke erwähnt, die mit einem Überzug aus Silikonharz mit einem hohen Anteil an einem bestimmten Metallstaub versehen sind. In dem Dokument wird diese Ausführungsform als nachteilig angesehen, da der Überzug in der Herstellung aufwendig und teuer sei und im industriellen Einsatz nur kurze Zeit erhalten bleibe, so daß seine Erneuerung oft erforderlich sei.

Die Feinleitertechnik erfordert zunehmend dünnere Kupferiaminatschichten. Damit soll erreicht werden, daß nach der Galvanisierung von Leiterplatten beim anschließenden Ätzen ein Unterätzen der feinen Leiterzüge vermieden wird. Deshalb wird mit Kupferbasisschichten mit einer Dicke von zum Beispiel nur noch 5 µm gearbeitet. Bei der SBU-Leiterplatten-Technik (SBU: Sequential Build Up) sind die elektrolytisch zu verstärkenden Schichten unter 1 µm dick. Die Stromstärke in der Klammer beträgt in den vorhandenen Anlagen 20 A bis 50 A je Leiterplattenseite. Erschwerend wirkt eine Anwendung der Reverse-Pulsestrom-Technik. Bei einer mit der Gleichstromtechnik vergleichbaren Metallabscheidungsgeschwindigkeit ist wegen des metallauflösenden Rückwärtsstromes die über jeden Kontakt zu übertragende effektive Leistung nochmals um ca. 25 % höher. Bei diesen extremen Anforderungen versagen bekannte Klammerkontakte. Dies gilt sowohl für die Leiterplattentechnik in Tauchbadanlagen als auch in Durchlaufanlagen. Ebenso gilt dies für das Galvanisieren von anderen Kunststoffteilen mittels Gestellen in Tauchbadanlagen bei vergleichbaren Verhältnissen.

Der vorliegenden Erfindung liegt von daher die Aufgabe zugrunde, die Nachteile der bekannten Verfahren und Vorrichtungen zu vermeiden und insbesondere die elektrische Kontaktierung und elektrolytische Behandlung von sehr dünnen, elektrisch leitfähigen Schichten insbesondere mit hohem Elektrolysestrom zu ermöglichen, wobei ein Abscheiden von Metall am Rand des leitfähigen Kontaktierelements während der Metallisierung des behandlungsgates vermieden werden soll. Dies schließt auch die Aufgabe ein, dünne, leitfähige Schichten nach der sogenannten Direktmetallisierungsmethode zu behandeln.

Gelöst wird die Aufgabe durch die in Patentanspruch 1 beschriebene Vorrichtung und durch das in Anspruch 12 beschriebene Verfahren. Vorteilhafte Weiterbildungen der Erfindung sind in den Unteransprüchen wiedergegeben.

Die erfindungsgemäße Vorrichtung und das Verfahren dienen zum elektrischen Kontaktieren von elektrolytisch zu behandelndem Gut. Zur elektrischen Kontaktierung umfaßt die Vorrichtung Kontaktträger mit Kontaktierelementen zur Stromzuführung zum Behandlungsgut, insbesondere Galvanisiergut wobei die zumindest mit dem Behandlungsgut in elektrischen Kontakt bringbaren Kontaktflächen der Kontaktierelemente aus elastischem Werkstoff gebildet sind, der zudem elektrisch leitfähig sein muß. In erfindungsgemäßer Weise sind im Bereich um die Kontaktierelemente herum elastische, elektrisch nichtleitende Umkleidungen angeordnet. Als Kontaktträger sind vor allem Klammern, Zangen, Klemmen, Bügel und Federn mit einem oder zwei beweglichen Schenkeln geeignet. Mechanische Toleranzen, die bei flächig auf das Behandlungsgut aufsetzenden Kontaktierelernenten auftreten, werden über elektrisch leitfähige Oberflächen aus dem elastischen Werkstoff so ausgeglichen, daß elektrolytischer Behandlungsstrom, insbesondere Galvanisierstrom, über die gesamte Fläche des Kontaktierelements übertragen wird.

Durch eine Vorrichtung zum Klemmen und elektrischen Kontaktieren des Behandlungsgutes mit dem elastischen Kontaktwerkstoff, der zugleich elektrisch sehr gut leitfähig ist, werden beim Ergreifen des Behandlungsgutes mittels der genannten Klammern, Klemmen usw. die immer auftretenden mechanischen Toleranzen bei an sich planparallelen Flächenkontaktierelementen vollkommen ausgeglichen. Auch Verformungen des Behandlungsgutes, wie zum Beispiel Wölbungen an Leiterplatten oder Rundungen an Form-Artikeln selbst, werden ausgeglichen. Die Schließkraft und damit auch die Kraft, die zur toleranzausgieichenden Verformung des elastischen Kontaktwerkstoffes erforderlich ist, kann in der Regel von einer Feder aufgebracht werden. Im Gegensatz zu bekannten Kontaktiereinrichtungen wird mit der erfindungsgemäßen Vorrichtung wegen der großen Auflagefläche oder wegen sehr vieler Auflagepunkte außerdem eine mechanische Beschädigung der Oberfläche des Behandlungsgutes mit Sicherheit vermieden. Damit wird überraschend in allen Fällen eine problemlose Stromübertragung gewährleistet.

Im Gegensatz hierzu können empfindliche Schichten an der Oberfläche von Galvanisiergut beispielsweise mit der in DE 36 12 220 C2 beschriebenen Vorrichtung leicht beschädigt werden. Dies hat zur Folge, daß die leitfähige Schicht an der Oberfläche unterbrochen und der Stromübergang von der Klammer zum Behandlungsgut behindert oder ganz unterbrochen wird. Werden mit dieser bekannten Vorrichtung ferner Platten mit unterschiedlicher Dicke behandelt und hierzu mit der Haltezange gehalten, sitzen gegebenenfalls nicht alle Vorsprünge an der Haltezange gleichmäßig auf den Oberflächen der Platte auf, so daß die Platte in diesem Falle nur ungenügend elektrisch kontaktiert wird. Nur bei einer für eine vorgegebene Haltezange festgelegten Dicke des Behandlungsgutes sitzen alle vier Klemmvorsprünge gleich gut auf der Oberfläche der Platte auf. Dies ist auch dann der Fall, wenn sich bei anderen Dicken jeweils zwei Klemmvorsprünge in die Oberfläche eingraben können. In diesem Falle wird die Oberfläche beschädigt, und bei dünnen elektrisch leitfähigen Oberflächenschichten, wie zum Beispiel bei Folien, wird die elektrische Kontaktierung dadurch unzuverlässig. Bei hohen Galvanisierströmen treten unter diesen Bedingungen an den Kontaktpunkten Verbrennungen auf.

Die genannten Probleme sollen sich bei der in EP-A 0 254 962 beschriebenen Vorrichtung dadurch nicht einstellen, daß eine Parallelführung, bestehend aus einem Mitnehmerstift und Nuten, ein Aufsetzen der Kontakte auf deren gesamter Fläche ermöglichen soll. Es hat sich jedoch herausgestellt, daß dies durch das technisch erforderliche Spiel im Mitnehmerstift sowie durch immer auftretende Fertigungstoleranzen in der Praxis unmöglich ist. Die Klemmbacken werden bestenfalls linienförmig, praktisch aber nur an einer Ecke ihrer Kontaktflächen aufsitzen. Schon toleranzbedingte Abstände von der Kontaktfläche zur Oberfläche der Leiterplatte im Mikrometerbereich tragen nicht mehr zur Übertragung des erforderlichen hohen Stromes bei. Die Stromdichte und damit auch der Spannungsabfall am Kontaktübergangswiderstand und die Verlustleistung an der kleinen kontaktgebenden Ecke werden daher extrem hoch. Die Kontaktstelle erwärmt sich in der Folge sehr stark. Bei ausreichender Schichtdicke der elektrisch leitfähigen Oberfläche des Behandlungsgutes kann diese Wärme abgeführt werden. Bei Leiterplatten ist dies bei den bisher üblichen Kupferschichtdicken von 17 µm auf den isolierenden Laminaten noch möglich. Im Ausnahmefällen treten aber bereits bei dieser Schichtdicke sogenannte Klammerdurchbrennstellen auf.

Die vorgenannten Nachteile der bekannten Vorrichtungen treten bei Verwendung der erfindungsgemäßen Vorrichtung nicht auf. Selbst Materialien mit sehr dünnen elektrisch leitfähigen Schichten können mit hoher Stromdichte behandelt werden, ohne daß die Schichten beschädigt werden.

Bei sehr dünnen elektrisch leitfähigen Schichten, die elektrolytisch zu verstärken sind, ist es vorteilhaft, wenn die Übergangslinie des stromzuführenden Kontaktierelements vom Kontaktrand zum Behandlungsgut besonders groß ist. Wenn also ein rundes Kontaktierelement einen großen Umfang aufweist oder wenn es als längliches Kontaktierelement besonders lang ausgebildet ist, kann ein großer Strom übertragen werden. Gleiches wird erreicht, wenn sehr viele Punkte einer Kontaktfläche die Oberfläche des Behandlungsgutes sicher berühren und somit kontaktieren. Dies ist ebenfalls nur durch einen in sich elastischen Kontaktwerkstoff realisierbar. Die Stromdichte im Kontaktierelement und im Bereich der umgebenden Oberfläche des Behandlungsgutes liegt dann im zulässigen Bereich. Dadurch werden Anbrennungen bei der Kontaktgebung vermieden. Bei den großen Kontaktierelementen wirken sich jedoch mechanische Toleranzen wegen der großen Auflagefläche besonders stark aus. Ohne Verwendung des erfindungsgemäßen Kontaktierelements würden nur Bruchteile der Fläche des metallischen Kontaktes auf der Oberfläche des Behandlungsgutes aufliegen, so daß Strom mit allen geschilderten Nachteilen in das Behandlungsgut eingeleitet wird. Zu diesen Toleranzen im Mikrometerbereich zählen auch die Unebenheiten der Kontaktoberflächen. Selbst wenn groß dimensionierte starre Kontakte planparallel aufsetzen, vermeiden diese Unebenheiten ohne Verwendung des erfindungsgemäßen Kontaktierelements wiederum eine gleichmäßige Stromverteilung über die gesamte metallische Kontaktfläche.

Daher wirkt sich die Erfindung besonders bei großflächigen Kontaktierelementen vorteilhaft aus. Bei Gestellware wird das Behandlungsgut zum Beispiel mittels einer Feder gegen ein flaches Widerlager gedrückt. Zur Stromzuführung zum Behandlungsgut werden die Kontaktträger, beispielsweise Kontaktbügel, hierzu mit den Kontaktierelementen an zur Halterung des Behandlungsgutes dienenden Gestellen angeordnet, wobei mindestens ein federnd befestigter Kontaktträger und mindestens ein starr befestigter Kontaktträger zur Halterung der Ware, insbesondere von plattenförmigem Behandlungsgut, vorgesehen sind. Zur elektrischen Kontaktierung drückt der federnd befestigte Kontaktträger das Behandlungsgut über ein Kontaktierelement gegen ein zweites Kontaktierelement am starr befestigten Kontaktträger.

Auch das lNiderlager an dem vorstehend beschriebenen Warengestell ist in vorteilhafter Weise mit dem elastischen Kontaktwerkstoff versehen. Durch den elastischen Kontaktwerkstoff wird in allen Fällen eine ideale Kontaktgabe sichergestellt. Toleranzen der Planparallelität von Kontaktierelementen und Widerlagern sowie Wölbungen und andere Unebenheiten des Behandlungsgutes werden in hohem Maße ebenso ausgeglichen wie die Oberflächenunebenheiten des Kontaktierelements selbst. Dies erlaubt auch eine geringere Präzision bei der Herstellung der Klammern, Klemmen und anderen Kontaktträgern sowie der Kontaktierelemente. Wesentliche Kosteneinsparungen sind damit möglich. Die Härte des elastischen Kontaktwerkstoffes liegt im Bereich von 10 bis 70 Shore A nach DIN 53 505.

Als elastische Kontaktwerkstoffe kommen Metall/Kunststoff-Verbundwerkstoffe, insbesondere aus einem elastischen Kunststoff mit einem hohen Anteil an elektrisch leitfähigen Füllstoffen gebildete Verbundwerkstoffe, in Frage. Sie bestehen aus Elastomeren, wie Kautschuk, Silikon oder anderen elastischen Kunststoffen, die elektrochemisch beständig sind. Hierzu gehören auch nicht vollkommen aushärtende Leitklebstoffe, wie sie in der Elektronikfertigung Verwendung finden. Derartigen Werkstoffen wird bei der Herstellung ein elektrisch leitfähiger Füllstoff beigemischt. Dadurch entsteht der Metall/Kunststoff-Verbund.

Die Füllstoffe, auch Einlagerungskomponenten genannt, bestehen für diesen Anwendungsfall bevorzugt aus Metall in Form von Pulver, Fasern, Nadeln, Zylindern, Kugeln, Flocken, Filz und anderen Formen. Die Abmessungen dieser Füllstoffe liegen im Bereich von Manometern bis zu etwa 100 Mikrometern. Die Faserlängen haben Durchmesser und Längen von einigen Nanometern bis zu einigen Millimetern. Der Anteil des Füllstoffes an dem gesamten Kontaktwerkstoff beträgt bis zu 90 Gewichtsprozent. Mit zunehmendem Füllstoffanteil nimmt die Elastizität des Metall/Kunststoff-Verbundes ab und die elektrische Leitfähigkeit zu. Beide Größen werden an den jeweiligen Anwendungsfall angepaßt. Als Füllstoffe eignen sich alle elektrochemisch beständigen Werkstoffe, die zugleich elektrisch leitfähig sind. Übliche Füllstoffe sind beispielsweise Titan, Niob, Platin, Gold, Silber, Edelstahl und Elektrokohle. Verwendbar sind zum Beispiel auch platinierte oder vergoldete Partikel, wie Kugeln aus Titan, Kupfer, Aluminium oder Glas.

Vorteilhaft bei der Herstellung eines Metall/Kunststoff-Verbundes ist ein leichter Werkstoff, wie Glas, Aluminium oder Titan. Die erforderliche elektrische Leitfähigkeit der vergleichsweise leichten Partikel wird beispielsweise durch eine elektrolytische Beschichtung mit Platin, Gold oder Silber hergestellt. Bei nicht beschichteten Titan- oder Aluminiumpartikeln würde die Metalloxidation eine sehr gute elektrische Leitfähigkeit verhindern. Ganz besonders vorteilhaft sind metallische Hohlkugeln. Sie sind elektrisch gut leitend und von geringem Gewicht. Herstellbar sind Kugeln mit einem Durchmesser von 0,2 mm und weniger. Die Wandstärke ist wählbar. Sie liegt im Bereich beispielsweise von 10 Mikrometer. Hier liegt somit ein Füllstoff vor, der ein spezifisches Gewicht aufweist, das durch Wahl der Kugelabmessungen, insbesondere der Wandstärke der Kugeln, an das spezifische Gewicht des elastischen Werkstoffes exakt angepaßt werden kann. Somit findet bei der Herstellung des Metall/Kunststoff-Verbundes keine Entmischung statt. Der Verbund ist hervorragend homogen.

Die leichten Füllstoffe neigen bei der Herstellung des Metall/Kunststoff-Verbundes während des Aushärtens nicht zur Entmischung. Der Verbund bleibt sehr homogen, so daß die elektrische Leitfähigkeit immer ausreichend hoch ist. Gleich gute Ergebnisse erzielt man mit Füllstoffpartikeln mit sehr kleinen Abmessungen, mit sogenannten nanostrukturierten Verbunden. Auch Metallfasern oder Metallflocken führen bei der Herstellung des elastischen und elektrisch leitfähigen Werkstoffes nur zu einer geringen Entmischung, das heißt zu einem homogenen Metall/Kunststoff-Verbund. Durch die Homogenität wird die Lebensdauer dieser elastischen, elektrischen Leiter verbessert. Der gesamte Leiterquerschnitt wird mit einer gleichen Stromdichte beaufschlagt. Örtliche Überhitzungen treten nicht auf.

Die mit diesen Füllstoffen erreichbare elektrische Leitfähigkeit des elastischen Kontaktwerkstoffes beträgt 10⁻³ Ωcm und in besonderen Fällen sogar 10⁻⁴ Ωcm. Dies stellt eine nur etwa zehnmal geringere Leitfähigkeit gegenüber der Leitfähigkeit der für elektrolytische Prozesse verwendbaren Metalle wie Titan dar.

Diese etwas geringere Leitfähigkeit des elastischen Kontaktwerkstoffes verursacht einen entsprechend höheren Spannungsabfall beim Stromfluß durch diesen Werkstoff. Damit entsteht eine größere Erwärmung, als bei herkömmlichen massiven metallischen Kontakten. Die erfindungsgemäßen Klammern, Zangen, Klemmen, Bügel und Federn sind vorzugsweise deshalb so aufgebaut, daß nur der jeweils vorderste Teil an den Auflageflächen zum Behandlungsgut mit dem elastischen Werkstoff belegt ist. Das heißt, es wird nur eine geringe Höhe des elastischen Kontaktierelementes gewählt, beispielsweise eine Höhe von ein oder zwei Millimeter. Damit können bereits alle Toleranzen, die praktisch vorkommen, sicher ausgeglichen werden. Der Gewinn an Stromübertragungsfähigkeit, der andererseits durch ein ideal aufliegendes Kontaktelement und damit durch einen idealen elektrischen Kontakt erzielt wird, ist um ein Vielfaches größer, insbesondere bei Kontaktierelementen mit großen Abmessungen, bezogen auf die beschriebene Übergangslinie um einen herkömmlichen Metallkontakt. Die zusätzliche Erwärmung durch den weniger leitfähigen elastischen Kontaktwerkstoff liegt in der Praxis im Rahmen der zulässigen Toleranz, zumal die entstehende Wärmebelastung pro Flächeneinheit insgesamt geringer ist als bei schlecht aufliegenden Metallkontakten. Außerdem kann ein großer Teil der Wärmeenergie in die Halteorgane der Kontaktierelemente (Klammer, Gestellbaum) abgeleitet werden.

Vorteilhaft wirkt sich auch der etwa dreimal höhere Reibwert des elastischen Kontaktwerkstoffes im Vergleich zu dem der bekannten Metallkontakte aus. Insbesondere in der Vertikaltechnik wird durch den höheren Reibwert das teilweise sehr schwere Behandlungsgut sicherer gehalten. Dies verhindert ein Herausfallen des Behandlungsgutes beim Transport oder beim Rütteln des Warenträgers.

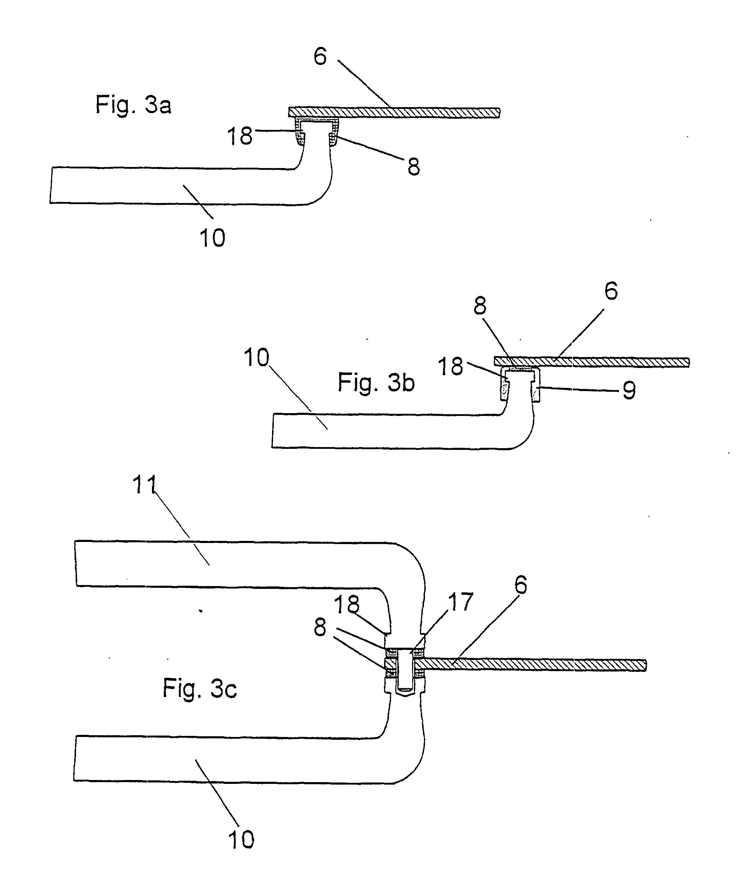

Zur Vermeidung des Herausfallens sind auch Metallkontaktträger bekannt, die an der Kontaktseite so abgesetzt sind, daß ein Stift durch ein Loch des Behandlungsgutes hindurch in den Gegenkontaktträger greift und diesen praktisch aufhängt. Auch derartig gestaltete Kontaktträger können zur gleichzeitigen guten Stromübertragung mit dem elastischen und elektrisch leitfähigen Kontaktwerkstoff gemäß der Erfindung kombiniert werden. Hierzu weisen die Kontaktträger mindestens zwei Tragarme auf, wobei der eine Tragarm im Kontaktierungsbereich mit einem Stift und der andere Tragarm im Kontaktierungsbereich mit einer Bohrung versehen sind, in die der Stift beim Herstellen eines elektrischen Kontaktes zwischen den Kontaktierelementen und dem Behandlungsgut eindringen kann (siehe hierzu **Fig. 3c**).

Auch die Verwendung von Kontaktformteiten als Kontaktierelemente, bestehend aus insbesondere feinfädiger Metallwolle oder entsprechendem Metallgewebe als federndem Leitwerkstoff, der elastisch, elektrisch leitfähig und thermisch beständig ist, mit oder ohne Kunststoffverbund (Kunststofffüllung), hat gute Ergebnisse gezeigt. Bei passergenauen Metallgeweben kann der Füllstoff teilweise oder vollkommen entfallen.

Die die Kontaktierelemente aufweisenden Kontaktträger können in unterschiedlichen Ausführungen hergestellt werden:

Beispielsweise kann ein elastisches, elektrisch leitfähiges Kontaktierelement durch Eindrücken in die Kontaktträger formschlüssig eingerastet sein. Dadurch wird ein einfacher Austausch der Kontaktierelemente gewährleistet.

In einer anderen Ausführungsform kann der elastische, elektrisch leitfähige Werkstoff auch stoffschlüssig und dadurch festhaftend sowie elektrisch leitfähig mit dem Kontaktträger verbunden werden, beispielsweise durch Vulkanisieren, durch Kleben mittels elektrisch leitfähigem Kleber oder durch Aufspritzen. Diese Ausführungsformen weisen den Vorteil einer hohen Beständigkeit gegen mechanische Belastungen und einer großen chemischen Beständigkeit gegen einen Angriff durch die Behandlungsflüssigkeiten auf.

Ferner kann der elastische, elektrisch leitfähige Werkstoff auch durch andere die Elastizität der Kontaktierelemente nicht beeinträchtigende Fügetechniken an den Kontaktträgern befestigt werden.

Das elastische Kontaktierelement kann insbesondere so ausgebildet sein, daß es im wesentlichen ausschließlich im Bereich der Kontaktflächen eine hohe elektrische Leitfähigkeit aufweist. Dadurch wird gewährleistet, daß sich bei Durchführung von elektrolytischen Metallisierungsverfahren kein Metall auf den Kontaktierelementen abscheidet. Vielmehr werden die Kontaktierelemente gegen das elektrische Feld abgeschirmt.

Zur näheren Erläuterung der Erfindung dienen die nachfolgend angegebenen Figuren. Es zeigen im einzelnen:
- **Fig. 1a, 1b**: beispielhaft den Aufbau einer Halte- und Kontaktierklammer sowie eines Haltegestelles in horizontalen (**Fig. 1a**) bzw. vertikalen Behandlungsanlagen (**Fig. 1b**), insbesondere Galvanisieranlagen, in der Seitenansicht;
- **Fig. 1c**: einen Schnitt eines Galvanisiergestelles in Draufsicht als Schnitt A-A von **Fig. 1b**;
- **Fig. 2a bis 2f**: erfindungsgemäße Ausführungsbeispiele von elastischen Kontaktierelementen an den Gestellen oder Klammern in Seitenansicht, bei denen die Klammer oder das Gestell mit einem elektrisch nichtleitenden Schutzüberzug versehen sind, um eine unerwünschte Abscheidung von Metall am Klammer- oder Gestellkörper zu vermeiden;
- **Fig. 3a bis 3c**: ausschnittsweise Gestelle oder Klammern, bei denen die Klammer- oder Gestellkörper aus blankem, leitfähigem Material hergestellt sind; hier sind im Galvanisierbad entsprechende Abblendvorrichtungen erforderlich, um unerwünschte Metallabscheidung zu verhindern.

Die **Fig. 1a bis 1c** geben den allgemeinen Aufbau von Halte- und Kontaktierungseinrichtungen für Behandlungsgut, insbesondere Galvanisiergut, wieder. Insofern stellen diese Figuren gleichzeitig auch den allgemeinen Aufbau bekannter Einrichtungen zum Halten und elektrischen Kontaktieren von Behandlungsgut dar, wenn an diesen nicht die erfindungsgemäßen Kontaktierelemente aus elastischem, elektrisch leitfähigem Werkstoff vorgesehen sind.
**Fig. 1a** zeigt ein Beispiel einer Klammereinrichtung in Seitenansicht, die für die Galvanisierung in horizontalen Durchlaufanlagen üblicherweise verwendet wird. Elektrische Stromzuführungen **1** verbinden die Klammereinrichtung über nicht dargestellte Schleifkontakte mit der ebenfalls nicht dargestellten Galvanisierstromquelle. Die Klammer, bestehend aus einem feststehenden Klammerarm **5** und einem federnd gelagerten Arm **4** ist mit dem feststehenden Teil **5** an einem Riemen oder einer Kette befestigt und läuft auf einer vorgegebenen Bahn endlos um. Über entsprechende Einrichtungen wird das Klammerteil **4** zu Beginn der Behandlungsstrecke in der Durchlaufanlage, nachdem das Behandlungsgut **6** (hier Leiterplatten) in die Anlage eingefahren ist, durch eine nicht dargestellte Feder geschlossen und festgehalten. An den Vorderteilen der Klammerteile **4** und **5** sind metallische, blanke Kontaktflächen angebracht, die den Galvanisierstrom auf das Behandlungsgut **6** übertragen. Die Klammerteile **4,5** tauchen zusammen mit dem Behandlungsgut **6** in die Badflüssigkeit ein. Die Flüssigkeit reicht in diesem Beispiel bis zu der mit **2** bezeichneten Linie. Zur weiteren Unterstützung und zum Transport des Behandlungsgutes **6** sind Achsen **3** mit Stützrädern in die Galvanisiereinrichtung eingebaut.

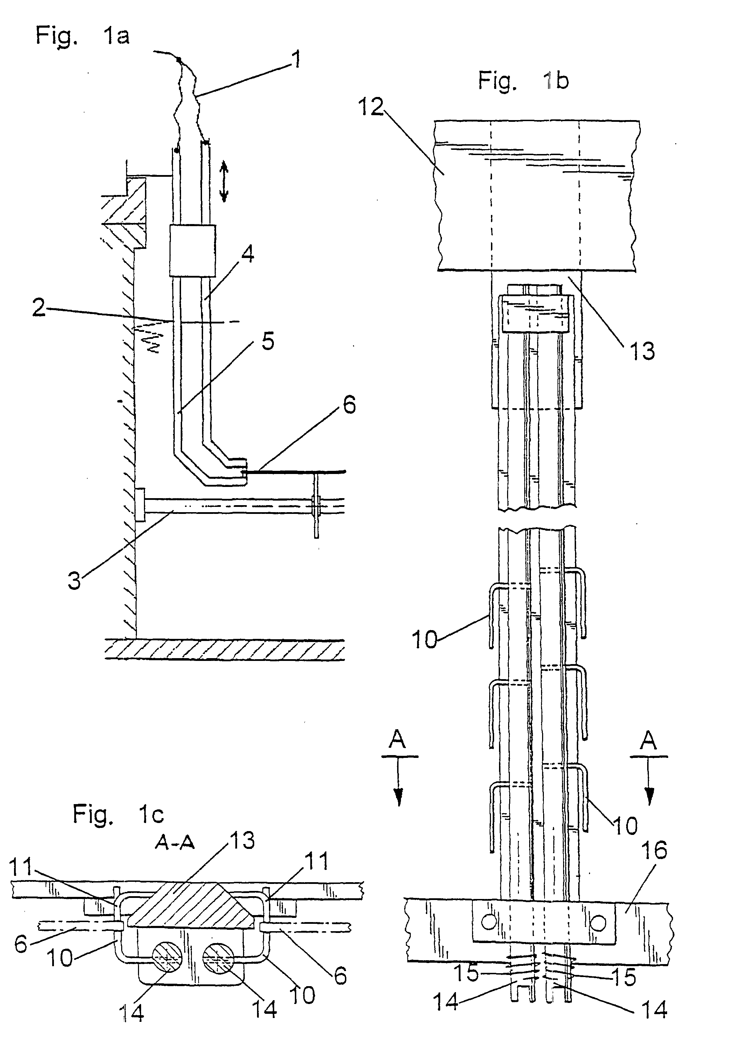

**Fig. 1b** und **1c** zeigen beispielhaft ein Gestell für die Leiterplattengalvanisierung in vertikalen Galvanisieranlagen. Der ausschnittsweise dargestellte Gestellträger **12,** an dem die einzelnen Drehstabträger **13** senkrecht in das Bad hineinragend befestigt sind, erstreckt sich über die gesamte Breite eines Galvanisierbades. Die Gestellklemmbügel **11** (in **Fig. 1b** nicht dargestellt) sind mit dem Drehstabträger **13** starr verbunden. Die Gestellklemmbügel **11** weisen an der dem Behandlungsgut **6** zugewandten Seite eine Kontaktfläche für das Halten des Behandlungsgutes und für die Stromzuführung auf, die im Falle der bekannten Vorrichtungen als Metalloberfläche ausgebildet und nicht elastisch ist. Im Falle einer Ausbildung dieser Vorrichtung im erfindungsgemäßen Sinne ist die Kontaktfläche des Gestellklemmbügels **11** mit einem elastischen, elektrisch leitfähigen Werkstoff gebildet. Unterhalb der Gestelle ist ein Stützrahmen **16** vorhanden, der zur Stabilisierung der bis zu 2 Meter nach unten in einen Behandlungsbehälter hineinragenden Drehstabträger **13** dient. Am Drehstabträger **13** sind in diesem Beispiel zwei drehbar gelagerte Stäbe **14** mit Gestellklemmbügeln **10** befestigt, so daß auf der linken und rechten Seite des Trägers **13** Behandlungsgut **6** befestigt werden kann. Falls das Gestell in herkömmlicher Weise ausgebildet ist, sind an den Bügeln **10** starre Metallflächen als Kontaktflächen vorgesehen. Im Falle einer erfindungsgemäßen Ausführung ist an dieser Stelle ein elastisches, elektrisch leitfähiges Kontaktierelement vorgesehen. Mittels der Federn **15** wird das in **Fig. 1b** nicht dargestellte Behaudlungsgut **6** festgeklemmt. Nach der Behandlung werden die Drehstäbe **14** mit nicht dargestellten Vorrichtungen gegen den Federdruck gedreht und damit das Gestell geöffnet. Das Behandlungsgut **6** kann in dieser Stellung von Hand oder mittels anderer Fiandhabungsmittel, zum Beispiel durch Roboter, aus dem Gestell entnommen werden. Die Gestelle eignen sich damit sehr gut für eine automatische Bestückung.

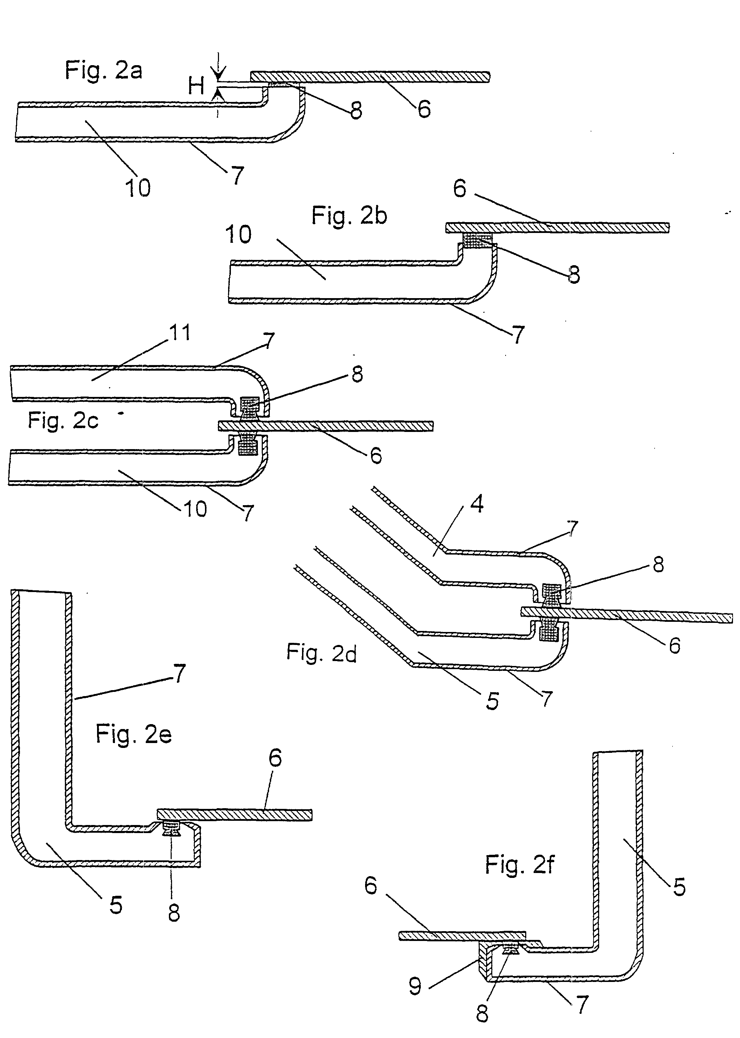

Die nachfolgend dargestellten Ausführungsformen der erfindungsgemäßen Kontaktierungsvorrichtungen können in den in **Fig. 1a** bis **1c** dargestellten Vorrichtungen vorgesehen werden. Sofern in den **Fig. 2a** bis **2f** lediglich ein einzelner Kontaktträger der jeweiligen Kontaktierungsvorrichtung gezeigt ist, kann zusätzlich ein weiterer Kontaktträger vorgesehen sein, um das Galvanisiergut beispielsweise durch Einklemmen zu halten. An dem zweiten, nicht dargestellten Kontaktträger kann ferner ebenso ein erfindungsgemäßes Kontaktierelement vorgesehen sein wie an dem jeweils dargestellten Kontaktträger, wobei die an den beiden Kontaktträgern vorgesehenen Kontaktierelemente vorzugsweise derart angeordnet sein können, daß sie einander direkt gegenüberliegen, um das Galvanisiergut zwischen sich festzuklemmen.

In **Fig. 2a** ist ausschnittweise der vordere Teil des Klemmbügels **10** an einem hier nicht dargestellten Drehstab gezeigt. Der Klemmbügel **10** ist mit einer nichtleitenden Kunststoffisolation **7** versehen. Damit wird verhinclert, daß der Klemmbügel **10** durch Kontakt mit der Behandlungsflüssigkeit elektrolytisch behandelt wird. Darüber hinaus wird damit auch erreicht, daß das Gestell als Raubkathode gegenüber dem Behandlungsgut **6** wirkt. Eine derartige Raubkathodenwirkung würde bei der Durchführung von Galvanisierungsverfahren zu geringeren Schichtdicken in den die Gestellklemmbügel **10** umgebenden Bereichen führen. Die Isolation besteht üblicherweise aus einem Kunststoff, wie Halar®. Das erfindungsgemäße elastische Kontaktierelement **8** ist an der blanken Spitze des Klemmbügels **10** elektrisch leitfähig aufgeklebt, aufgespritzt oder aufvulkanisiert. Unmittelbar gegenüberliegend ist der hier nicht dargestellte gleich gestaltete Klemmbügel **11** angebracht. Auch dieser weist ein elastisches Kontaktierelement **8** auf, so daß eine sichere und gleichmäßige Stromübertragung auf beide Seiten des Behandlungsgutes gewährleistet ist. Die Elastizität und die Höhe H des Kontaktierelements **8** sind so gewählt, daß alle Unebenheiten durch Toleranzen am Gestell und am Behandlungsgut **6** ausgeglichen werden können.

**Fig. 2b** und **Fig. 2c** stellen weitere Gestellklemmbügel **10,11** dar, bei denen die elastischen Kontaktierelemente **8** in einer anderen Form ausgeführt sind. In **Fig. 2b** ist das Kontaktierelement **8** seitlich in die Isolation **7** eingebettet, um die Abscheidung von Metall an dieser Stelle so weit wie möglich zu verhindern.

In **Fig. 2c** wird ein elastisches Kontaktierelement **8** gezeigt, das durch die Pilzform in den Gestellklemmbügeln gehalten wird. Ein Einkleben oder Vulkanisieren ist hier nicht erforderlich. Besonders vorteilhaft bei dieser Ausführungsform ist die leichte Austauschbarkeit des Kontaktierelements **8** im Falle einer Beschädigung oder des Verschleißes. Auch ein Anschrauben oder andere Fügetechniken, die die Elastizität der Kontaktierelemente **8** und Widerlager nicht beeinträchtigen, sind möglich.

**Fig. 2d** zeigt ein Klammerpaar, bei dem das Behandlungsgut **6** mittels des fest am nicht dargestellten Transportmittel befestigten Klammerteiles **5** und des beweglichen Klammerteiles **4** gegriffen wird. Dabei drückt eine nicht dargestellte Feder das Klammeroberteil **4** gegen das Klammerunterteil **5**. An den gebogenen Enden der Klammerteile **4,5** sind die elastischen, leitenden Kontaktierelemente **8** in entsprechende Bohrungen eingedrückt. Auch hier ist eine leichte Austauschbarkeit der elastischen Kontaktierelemente **8** gewährleistet.

**Fig. 2e** zeigt ein festes Klammerteil **5** mit dem Behandlungsgut **6**, bei dem das elastische Kontaktierelement **8** pilzförmig ausgebildet ist, um einen besonders festen Halt im Klammerteil **5** zu erreichen und trotzdem den leichten Austausch des Kontaktierelements **8** zu ermöglichen.

In erfindungsgemäßer Weise ist in **Fig. 2f** gegenüber **Fig. 2e** eine zusätzliche elastische Umkleidung **9** im Bereich um das elastische, elektrisch leitfähige Klammerkontaktierelement **8** herum angebracht. Beim Greifen der Klammer drückt sich der elastische, nichtleitende Überzug **9** gemeinsam mit dem leitenden Kontaktierelement **8** zusammen und gewährleistet einen sicheren Halt des Behandlungsgutes **6.** Ziel ist hier, das leitende Kontaktierelement **8** so einzubetten, daß sich unerwünschtes Metall am Rand des leitfähigen Kontaktierelements **8** während der Metallisierung des Behandlungsgutes nicht abscheidet. Derartige Metallschichten müßten vor einem weiteren Greifvorgang der Klammer abgetragen werden, und die Klammer müßte gereinigt werden, um die erforderliche Elastizität des Kontaktierelements **8** wiederherzustellen.

**Fig. 3a** bis **3c** zeigen ferner nicht isolierte Gestellklemmbügel **10,11**. Hier wird das elektrische Feld von den Kontaktträgern **10,11** mit anderen Mitteln, die im Bad angebracht sind, zum Beispiel von Blenden, abgeschirmt. Alternativ kann das Behandlungsgut **6** auch oberhalb des Badspiegels kontaktiert werden.

Im Falle der **Fig. 3a** ist das elastische, elektrisch leitfähige Kontaktierelement **8** über den Gestellklemmbügel **10** gestülpt und hinter dem Vorsprung **18** arretiert.

In erfindungsgemäßer Weise ist in **Fig. 3b** ein elektrisch leitend aufgeklebtes oder aufvulkanisiertes Kontaktierelement **8** dargestellt, das mit einer nichtleitenden, elastischen Isolierschicht **9** umkleidet ist, um unerwünschte Metallabscheidungen in Bereichen unmittelbar um das elastische, leitfähige Kontaktierelement **8** zu verhindern. Die elektrisch isolierende Umkleidung **9** und das Kontaktierelement **8** bestehen vorteilhaft aus einer Einheit mit unterschiedlicher elektrischer Leitfähigkeit. Diese Einheit wird beispielsweise auf den Klemmbügel **10** aufgestülpt.

In **Fig. 3c** sind ein fester Klemmbügel **10** und ein beweglicher Klemmbügel **11** mit den elastischen Kontaktierelementen **8** und dem Behandlungsgut **6** dargestellt. Außerdem ist am festen Klemmbügel **11** ein Stift **17** angebracht, der im geschlossenen Zustand in die Bohrung am beweglichen Klemmbilgel **10** hineinragt. Der Stift **17** greift durch eine entsprechende Bohrung im Behandlungsgut **6** hindurch und arretiert dieses absolut fest und passergenau. Auch hier gleichen die elastischen Kontaktierelemente **8** die Toleranzen aus. An die Stiftgenauigkeit werden keine hohen Anforderungen gestellt.

Alle Beispiele der elastischen, leitfähigen Kontaktierelemente können rotationssymmetrisch oder in die Zeichnungsebene hinein langgestreckt, zum Beispiel oval oder rechteckig, ausgeführt sein. Für die Anwendung in der Leiterplattentechnik kann die Grundfläche eines länglichen Kontaktierelements zum Beispiel 40 mal 2 Millimeter betragen.

Das elastische Kontaktierelement kann beispielsweise durch Stanzen, Schneiden, Formspritzen, Extrudieren oder Metalldrahtweben hergestellt werden. Das Aufstecken und Anschrauben des Kontaktierelements erlaubt einen einfachen Austausch, der bei Verschleiß von Zeit zu Zeit erforderlich ist. Auch bei bekannten Vorrichtungen mußten metallische Kontaktierelemente von Zeit zu Zeit erneuert werden. Durch die üblicherweise nur punktförmige Kontaktgabe und die dadurch bedingte sehr hohe örtliche Stromdichte nutzen sich diese Kontaktierelemente ebenfalls ab. Auch beim Entmetallisieren der Kontaktierialemente wird teilweise Metall abgetragen.

Bei Gestellen in Tauchbadanlagen kommen auch einseitige Stromzuführungen in Form von zum Beispiel einem Federbein und einem Gegenlager vor. Bei Gestellen mit einseitigem Widerlager für Leiterplatten und anderen einseitigen Klammern oder Klemmen kann auch die Gegenauflage, das heißt das Widerlager, elastisch und elektrisch leitfähig ausgeführt sein.

Beim Galvanisieren werden die elastischen Kontaktierelemente galvanisiert, wenn sie dem elektrischen Feld im Elektrolyten ausgesetzt sein sollten. In diesem Falle werden die Kontaktiermittel zur Reinigung regelmäßig entmetallisiert, um deren Elastizität zu erhalten. Dies geschieht entweder auf elektrolytischem oder chemischem Wege. Der elastische Kontaktwerkstoff wird so gewählt, daß er auch bei Durchführung des jeweiligen Entmetallisierungsverfahrens beständig ist.

Federnde Stromzuführungen werden bevorzugt zum Galvanisieren von geformten Artikeln, wie zum Beispiel Armaturen und anderen Hohlwaren, an Galvanisiergestellen verwendet. Oft handelt es sich hierbei um Kunststoffteile, deren metallisierte Oberflächen sehr empfindlich gegen Beschädigung sind. Die erfindungsgemäßen Kontaktierelemente sind auch für diesen Anwendungsfall vorteilhaft verwendbar.

### Bezugszeichenliste:

- **1**: Elektrische Stromzuführung
- **2**: Badspiegel
- **3**: Achse mit Stütz- und Transporträdern
- **4**: Bewegliches Klammerteil
- **5**: Festes Klammerteil
- **6**: Galvanisiergut/Behandlungsgut
- **7**: Kunststoffisolation
- **8**: Elastisches Kontaktierelement
- **9**: Elastische Kunststoffisolation
- **10**: Gestellklemmbügel, beweglich
- **11**: Gestellklemmbügel, fest
- **12**: Gestellträger
- **13**: Drehstabträger
- **14**: Drehstäbe
- **15**: Klemmfeder
- **16**: Stützrahmen
- **17**: Stift
- **18**: Vorsprung am Klemmbügel

## Patentansprüche

1. Vorrichtung zum elektrischen Kontaktieren von elektrolytisch zu behandelndem Gut, umfassend Kontaktträger (**4,5,10,11**) mit Kontaktierelementen (**8**) zur Stromzuführung zum Behandlungsgut (**6**), wobei zumindest die mit dem Behandlungsgut (**6**) in Kontakt bringbaren Kontaktflächen dieser Kontaktierelemente (**8**) aus elastischem, elektrisch leitfähigem Werkstoff gebildet sind, **dadurch gekennzeichnet, daß** elastische, elektrisch nichtleitende Umkleidungen (**9**) im Bereich um die Kontaktierelemente (**8**) herum angeordnet sind.

2. Vorrichtung nach Anspruch 1, **dadurch gekennzeichnet, daß** die Kontaktträger (**4,5,10,11**) als Klammern, Zangen, Klemmen, Bügeln oder Federn mit einem oder zwei beweglichen Schenkeln ausgebildet sind.

3. Vorrichtung nach einem der Ansprüche 1 und 2, **dadurch gekennzeichnet, daß** mindestens ein elastisches, elektrisch leitfähiges Kontaktierelement (**8**) durch Eindrücken in die Kontaktträger (**4,5,10,11**) formschlüssig eingerastet ist.

4. Vorrichtung nach einem der Ansprüche 1 und 2, **dadurch gekennzeichnet, daß** der elastische, elektrisch leitfähige Werkstoff durch Vulkanisieren, Kleben mittels elektrisch leitfähigem Kleber oder durch Aufspritzen festhaftend und elektrisch leitfähig auf die Kontaktträger (**4,5,10,11**) aufgebracht ist.

5. Vorrichtung nach einem der Ansprüche 1 und 2, **dadurch gekennzeichnet, daß** der elastische, elektrisch leitfähige Werkstoff durch eine die Elastizität der Kontaktierelemente nicht beeinträchtigende Fügetechnik an den Kontaktträgern (**4,5,10,11**) befestigt ist.

6. Vorrichtung nach einem der vorstehenden Ansprüche, **dadurch gekennzeichnet, daß** die Kontaktierelemente (**8**) aus einem elastischen Kunststoff mit einem hohen Anteil an elektrisch leitfähigen Füllstoffen gebildet sind.

7. Vorrichtung nach Anspruch 6, **dadurch gekennzeichnet, daß** die elektrisch leitfähigen Füllstoffe beständig sind gegen einen elektrolytischen und/oder chemischen Angriff.

8. Vorrichtung nach einem der Ansprüche 1 bis 5, **dadurch gekennzeichnet, daß** die Kontaktierelemente (**8**) aus einem elastischen, elektrisch leitfähigen, chemisch und thermisch beständigen, entsprechend geformten Metalidrahtgewebe ohne Kunststofffüllung gebildet sind.

9. Vorrichtung nach einem der vorstehenden Ansprüche, **dadurch gekennzeichnet, daß** das Kontaktierelement (**8**) so ausgebildet ist, daß es im wesentlichen ausschließlich im Bereich der Kontaktflächen eine hohe elektrische Leitfähigkeit aufweist.

10. Vorrichtung nach einem der vorstehenden Ansprüche, **dadurch gekennzeichnet, daß** die Kontaktträger (**4,5,10,11**) mindestens zwei Tragarme aufweisen, wobei der eine Tragarm (**5,11**) im Kontaktierungsbereich mit einem Stift (**17**) und der andere Tragarm (**4,10**) im Kontaktierungsbereich mit einer Bohrung versehen ist, in die der Stift (**17**) beim Herstellen eines elektrischen Kontaktes zwischen den Kontaktierelementen (**8**) und dem Behandlungsgut (**6**) eindringen kann.

11. Vorrichtung nach einem der vorstehenden Ansprüche, **dadurch gekennzeichnet, daß** die Kontaktträger (**10,11**) mit den Kontaktierelementen (**8**) an zur Halterung von plattenförmigem Behandlungsgut (**6**) dienenden Gestellen (**14**) angeordnet sind, wobei mindestens ein federnd befestigter Kontaktträger (**10**) und mindestens ein starr befestigter Kontaktträger (**11**) zur Halterung des Behandlungsgutes (**6**) vorgesehen sind und der federnd befestigte Kontaktträger (**10**) das Behandlungsgut (**6**) über ein Kontaktiereiement (**8**) gegen ein zweites Kontaktierelement (**8**) am starr befestigten Kontaktträger (**11**) drückt.

12. Verfahren zum elektrischen Kontaktieren von elektrolytisch zu behandelndem Gut, bei dem das Behandlungsgut (**6**) über an Kontaktträgern (**4,5,10,11**) angeordnete Kontaktierelemente (**8**) elektrisch kontaktiert wird, wobei mechanische Toleranzen, die bei flächig auf das Behandlungsgut (**6**) aufsetzenden Kontaktierelementen (**8**) auftreten, über elektrisch leitfähige Oberflächen aus einem elastischen leitfähigen Werkstoff so ausgeglichen werden, daß Elektrolysestrom über die gesamte Fläche des Kontaktierelements (**8**) übertragen wird, **dadurch gekennzeichnet, daß** im Bereich um die Kontaktierelemente (**8**) heirum angeordnete, elastische, elektrisch nichtleitende Umkleidungen (**9**) vorgesehen werden.

13. Verfahren nach Anspruch 12, **dadurch gekennzeichnet, daß** Strom zum Behandlungsgut (**6**) über als Klammern, Zangen, Klemmen, Bügeln oder Fedem mit einem oder zwei beweglichen Schenkeln ausgebildete Kontaktträger (**4,5,10,11**) zugeführt wird.

14. Verfahren nach einem der Ansprüche 12 und 13, **dadurch gekennzeichnet, daß** Strom zum Behandlungsgut (**6**) über mindestens ein in die Kontaktträger (**4,5,10,11**) durch Eindrücken formschlüssig eingerastetes, elastisches, elektrisch leitfähiges Kontaktierelement (**8**) zugeführt wird.

15. Verfahren nach einem der Ansprüche 12 und 13, **dadurch gekennzeichnet, daß** Strom zum Behandlungsgut (**6**) über mindestens ein Kontaktierelement (**8**) zugeführt wird, das durch Vulkanisieren, Kleben mittels elektrisch leitfähigem Kleber oder durch Aufspritzen eines festhaftend und elektrisch leitfähig auf die Kontaktträger (**4,5,10,11**) aufgebrachten, elastischen, elektrisch leitfähigen Werkstoffes hergestellt ist.

16. Verfahren nach einem der Ansprüche 12 und 13, **dadurch gekennzeichnet, daß** Strom zum Behandlungsgut (**6**) über mindestens ein Kontaktierelement (**8**) zugeführt wird, bei dem der elastische, elektrisch leitfähige Werkstoff durch eine die Elastizität der Kontaktierelemente nicht beeinträchtigende Fügetechnik an den Kontaktträgern (**4,5,10,11**) befestigt ist.

17. Verfahren nach einem der Ansprüche 12 bis 16, **dadurch gekennzeichnet, daß** Strom zum Behandlungsgut (**6**) über mindestens ein Kontaktierelement (**8**) zugeführt wird, das aus einem elastischen Kunststoff mit einem hohen Anteil an elektrisch leitfähigen Füllstoffen gebildet ist.

18. Verfahren nach Anspruch 17, **dadurch gekennzeichnet, daß** für die elektrisch leitfähigen Füllstoffe Materialien ausgewählt werden, die beständig sind gegen einen elektrolytischen und/oder chemischen Angriff.

19. Verfahren nach einem der Ansprüche 12 bis 16, **dadurch gekennzeichnet, daß** Strom zum Behandlungsgut (**6**) über mindestens ein Kontaktierelement (**8**) zugeführt wird, das aus einem elastischen, elektrisch leitfähigen, chemisch und thermisch beständigen, entsprechend geformten Metalldrahtgewebe ohne Kunststofffüllung gebildet ist.

20. Verfahren nach einem der Ansprüche 12 bis 19, **dadurch gekennzeichnet, daß** Strom zum Behandlungsgut (**6**) über mindestens ein Kontaktiereiement (**8**) zugeführt wird, das so ausgebildet ist, daß es im wesentlichen ausschließlich im Bereich der Kontaktflächen eine hohe elektrische Leitfähigkeit aufweist.

21. Verfahren nach einem der Ansprüche 12 bis 20, **dadurch gekennzeichnet, daß** Strom über jeweils mindestens zwei Tragarme aufweisende Kontaktträger (**4,5,10,11**) zum Behandlungsgut (**6**) zugeführt wird, wobei der eine Tragarm (**5,11**) eines Kontaktträgers (**4,5,10,11**) im Kontaktierungsbereich mit einem Stift (**17**) und der andere Tragarm (**4,10**) im Kontaktierungsbereich mit einer Bohrung versehen ist, in die der Stift (**17**) beim Herstellen eines elektrischen Kontaktes zwischen den Kontaktierelementen (**8**) und dem Behandlungsgut (**6**) eindringt.

22. Verfahren nach einem der Ansprüche 12 bis 21, **dadurch gekennzeichnet, daß** Strom zum Behandlungsgut (**6**) über mindestens ein Kontaktierelement (**8**) zugeführt wird, das an Kontaktträgem (**10,11**) angeordnet ist, wobei die Kontaktträger (**10,11**) an zur Halterung des Behandlungsgutes dienenden Gestellen (**14**) angeordnet sind, wobei ferner mindestens ein federnd befestigter Kontaktträger (**10**) und mindestens ein starr befestigter Kontaktträger (**11**) zur Halterung von plattenförmigem Behandlungsgut (**6**) vorgesehen sind und der federnd befestigte Kontaktträger (**10**) das Behandlungsgut (**6**) über ein Kontaktierelement (**8**) gegen ein zweites Kontaktierelement (**8**) am starr befestigten Kontaktträger (**11**) drückt.

## Claims

1. Device for providing electrical contact to goods which are to be treated electrolytically, said device comprising contact carriers (4, 5, 10, 11) which have contact elements (8) for supplying current to the goods to be treated (6), at least the contact areas of these contact elements (8), which areas can be brought into contact with the goods to be treated (6), being formed from resilient, electrically conductive material, **characterised in that** resilient, electrically non-conductive sheathings (9) are arranged in the region around the contact elements (8).

2. Device according to claim 1, **characterised in that** the contact carriers (4, 5, 10, 11) are in the form of clamps, tongs, clips, bows or springs having one or two displaceable legs.

3. Device according to one of claims 1 and 2, **characterised in that** at least one resilient, electrically conductive contact element (8) is engaged as a form-fit by being pressed into the contact carriers (4, 5, 10, 11).

4. Device according to one of claims 1 and 2, **characterised in that** the resilient, electrically conductive material is applied to the contact carriers (4, 5, 10, 11) by vulcanising, by bonding using electrically conductive adhesive, or by spraying on so that it is tightly adherent and electrically conductive.

5. Device according to one of claims 1 and 2, **characterised in that** the resilient, electrically conductive material is secured to the contact carriers (4, 5, 10, 11) by a joining technique which does not impair the elasticity of the contact elements.

6. Device according to one of the preceding claims, **characterised in that** the contact elements (8) are formed from a resilient plastics material which has a high proportion of electrically conductive fillers.

7. Device according to claim 6, **characterised in that** the electrically conductive fillers are resistant to electrolytic and/or chemical attack.

8. Device according to one of claims 1 to 5, **characterised in that** the contact elements (8) are formed from a resilient, electrically conductive, chemically and thermally stable, appropriately shaped metal wire fabric without any plastics material filling.

9. Device according to one of the preceding claims, **characterised in that** the contact element (8) is so configured that it has a high electrical conductivity substantially only in the region of the contact areas.

10. Device according to one of the preceding claims, **characterised in that** the contact carriers (4, 5, 10, 11) have at least two supporting arms, the one supporting arm (5, 11) being provided with a pin (17) in the contacting region and the other supporting arm (4, 10) being provided with a bore in the contacting region, into which the pin (17) can penetrate when electrical contact is established between the contact elements (8) and the goods to be treated (6).

11. Device according to one of the preceding claims, **characterised in that** the contact carriers (10, 11) are arranged with the contact elements (8) on racks (14) which serve to hold board-shaped goods to be treated (6), at least one spring-mounted contact carrier (10) and at least one rigidly mounted contact carrier (11) being provided for holding the goods (6) to be treated, and the spring-mounted contact carrier (10) pressing the goods (6) to be treated via one contact element (8) against a second contact element (8) on the rigidly mounted contact carrier (11).

12. Method for providing electrical contact to goods which are to be treated electrolytically, in which method the goods (6) to be treated are electrically contacted via contact elements (8) arranged on contact carriers (4, 5, 10, 11), mechanical tolerances, which occur with contact elements (8) which are placed flat on the goods (6) to be treated, being so compensated via electrically conductive surfaces of a resilient conductive material, that electrolysis current is transmitted over the entire surface of the contact element (8), **characterised in that** resilient, electrically non-conductive sheathings (9) are provided disposed in the region around the contact elements (8).

13. Method according to claim 12, **characterised in that** current is supplied to the goods (6) to be treated via contact carriers (4, 5, 10, 11) in the form of clamps, tongs, clips, bows or springs having one or two displaceable legs.

14. Method according to one of claims 12 and 13, **characterised in that** current is supplied to the goods (6) to be treated via at least one resilient, electrically conductive contact element (8) which is engaged in the contact carriers (4, 5, 10, 11) by being pressed in as a form-fit.

15. Method according to one of claims 12 and 13, **characterised in that** current is supplied to the goods (6) to be treated via at least one contact element (8) which is produced by vulcanising, by bonding using electrically conductive adhesive or by spraying on a resilient, electrically conductive material applied to the contact carriers (4, 5, 10, 11) so that it is tightly adherent and electrically conductive.

16. Method according to one of claims 12 and 13, **characterised in that** current is supplied to the goods (6) to be treated via at least one contact element (8) in which the resilient, electrically conductive material is secured to the contact carriers (4, 5, 10, 11) by a joining technique which does not impair the elasticity of the contact elements.

17. Method according to one of claims 12 to 16, **characterised in that** current is supplied to the goods (6) to be treated via at least one contact element (8) which is formed from a resilient plastics material which has a high proportion of electrically conductive fillers.

18. Method according to claim 17, **characterised in that,** for the electrically conductive fillers, materials are selected which are resistant to electrolytic and/or chemical attack.

19. Method according to one of claims 12 to 16, **characterised in that** current is supplied to the goods (6) to be treated via at least one contact element (8) which is formed from a resilient, electrically conductive, chemically and thermally stable, appropriately shaped metal wire fabric without any plastics material filling.

20. Method according to one of claims 12 to 19, **characterised in that** current is supplied to the goods (6) to be treated via at least one contact element (8) which is so configured that it has a high electrical conductivity substantially only in the region of the contact areas.

21. Method according to one of claims 12 to 20, **characterised in that** current is supplied to the goods (6) to be treated via contact carriers (4, 5, 10, 11) which each have at least two supporting arms, the one supporting arm (5, 11) of a contact carrier (4, 5, 10, 11) being provided with a pin (17) in the contacting region and the other supporting arm (4, 10) being provided with a bore in the contacting region, into which the pin (17) penetrates when electrical contact is established between the contact elements (8) and the goods (6) to be treated.

22. Method according to one of claims 12 to 21, **characterised in that** current is supplied to the goods to be treated (6) via at least one contact element (8) which is arranged on contact carriers (10, 11), the contact carriers (10, 11) being arranged on racks (14) which serve to hold the goods to be treated, and furthermore at least one spring-mounted contact carrier (10) and at least one rigidly mounted contact carrier (11) being provided for holding board-shaped goods to be treated (6), and the spring-mounted contact carrier (10) pressing the goods (6) to be treated via one contact element (8) against a second contact element (8) on the rigidly mounted contact carrier (11).

## Revendications

1. Dispositif pour le contact électrique d'un objet à traiter de façon électrolytique, comprenant des supports de contact (4, 5, 10, 11) avec des éléments de connexion (8) pour l'arrivée de courant vers l'objet à traiter (6), sachant qu'au moins les surfaces de contact de ces éléments de connexion (8) pouvant être mises en contact avec l'objet à traiter (6) sont à base de matériau élastique conducteur, **caractérisé en ce que** des revêtements élastiques isolants (9) sont agencés dans la zone autour des éléments de connexion (8).

2. Dispositif selon la revendication 1, **caractérisé en ce que** les supports de contact (4, 5,10,11) sont réalisés comme un moyen d'accrochage, de pinçage, de serrage, d'étendage ou de ressort avec une ou deux branches mobiles.

3. Dispositif selon l'une quelconque des revendications 1 et 2, **caractérisé en ce qu'**au moins un élément de connexion (8) élastique conducteur est encliqueté par pression selon un engagement positif dans les supports de contact (4,5,10,11).

4. Dispositif selon l'une quelconque des revendications 1 et 2, **caractérisé en ce que** le matériau élastique conducteur est introduit de façon fixe et conductrice de l'électricité par vulcanisation, par collage au moyen d'un agent adhésif conducteur ou par application au pistolet dans les supports de contact (4, 5, 10, 11).

5. Dispositif selon l'une quelconque des revendications 1 et 2, **caractérisé en ce que** le matériau élastique conducteur est fixé aux support de contact (4, 5, 10, 11) par une technique d'assemblage qui ne diminue pas l'élasticité des éléments de connexion.

6. Dispositif selon l'une quelconque des revendications précédentes, **caractérisé en ce que** les éléments de connexion (8) sont à base de matière plastique élastique avec une teneur élevée en charges conductrices.

7. Dispositif selon la revendication 6, **caractérisé en ce que** les charges conductrices sont résistantes à une attaque électrolytique et/ou chimique.

8. Dispositif selon l'une quelconque des revendications 1 à 5, **caractérisé en ce que** les éléments de connexion (8) sont à base d'une toile de fil de métal élastique conductrice et résistante chimiquement et thermiquement formée de façon correspondante sans rembourrage en plastique.

9. Dispositif selon l'une quelconque des revendications précédentes, **caractérisé en ce que** l'élément de connexion (8) est réalisé de telle sorte qu'il comprend en substance, hormis au niveau des surfaces de contact, une conductivité électrique élevée.

10. Dispositif selon l'une quelconque des revendications précédentes, **caractérisé en ce que** les supports de contact (4, 5, 10, 11) comprennent au moins deux bras porteurs, sachant que l'un d'eux (5, 11) est muni dans la zone de connexion d'une tige (17) et que l'autre (4, 10) est muni dans la zone de connexion d'un trou dans lequel la tige (17) peut pénétrer lorsqu'un contact électrique est produit entre les éléments de connexion (8) et l'objet à traiter (6).

11. Dispositif selon l'une quelconque des revendications précédentes, **caractérisé en ce que** les supports de contact (10, 11) sont agencés avec les éléments de connexion (8) sur les bâtis (14) servant à la fixation de l'objet à traiter (6) de forme plate, sachant qu'au moins un support de contact (10) fixé de manière élastique et au moins un support de contact (11) fixé de manière fixe sont prévus pour la fixation de l'objet à traiter (6) et que le support de contact (10) fixé de manière élastique presse l'objet à traiter (6) par l'intermédiaire d'un élément de connexion (8) contre un second élément de connexion (8) au niveau du support de contact (11) fixé de manière fixe.

12. Procédé pour le contact électrique d'un objet à traiter de façon électrolytique, avec lequel l'objet à traiter (6) est mis en contact électriquement par l'intermédiaire d'éléments de connexion (8) agencés sur les supports de contact (4, 5, 10, 11), sachant que des tolérances mécaniques, qui surviennent lorsque des éléments de connexion sont posés de manière plate sur l'objet à traiter (6), sont compensées par l'intermédiaire de surfaces conductrices à base de matériau élastique conducteur de telle sorte qu'un courant d'électrolyse est transmis par l'intermédiaire de l'ensemble de la surface de l'élément de connexion (8), **caractérisé en ce que** dans la zone autour des éléments de connexion (8) des revêtements (9) élastiques isolants agencés autour sont prévus.

13. Procédé selon la revendication 12, **caractérisé en ce que** le courant est conduit à l'objet à traiter (6) par l'intermédiaire des supports de contact (4, 5, 10, 11) réalisés comme un moyen d'accrochage, de pinçage, de serrage, d'étendage ou de ressort avec une ou deux branches mobiles.

14. Procédé selon l'une quelconque des revendications 12 et 13, **caractérisé en ce que** le courant est conduit à l'objet à traiter (6) par l'intermédiaire d'au moins un élément de connexion (8) élastique conducteur encliqueté par pression selon un engagement positif dans les supports de contact (4, 5, 10, 11).

15. Procédé selon l'une quelconque des revendications 12 et 13, **caractérisé en ce que** le courant est conduit à l'objet à traiter (6) par l'intermédiaire d'au moins un élément de connexion (8) qui est fabriqué par vulcanisation, par collage au moyen d'un agent adhésif conducteur ou par application au pistolet d'un matériau élastique conducteur appliqué de manière fixe et conductrice de l'électricité sur les supports de contact (4, 5, 10, 11).

16. Procédé selon l'une quelconque des revendications 12 et 13, **caractérisé en ce que** le courant est conduit à l'objet à traiter (6) par l'intermédiaire d'au moins un élément de connexion (8), avec lequel le matériau élastique conducteur est fixé aux supports de contact (4, 5, 10, 11) par une technique d'assemblage qui ne diminue pas l'élasticité des éléments de connexion.

17. Procédé selon l'une quelconque des revendications 12 à 16, **caractérisé en ce que** le courant est conduit à l'objet à traiter (6) par l'intermédiaire d'au moins un élément de connexion (8) qui est à base d'une matière plastique élastique avec une teneur élevée en charges conductrices.

18. Procédé selon la revendication 17, **caractérisé en ce que** pour les charges conductrices les matériaux choisis sont résistants à une attaque électrolytique et/ou chimique.

19. Procédé selon l'une quelconque des revendications 12 à 16, **caractérisé en ce que** le courant est conduit à l'objet à traiter (6) par l'intermédiaire d'au moins un élément de connexion (8) qui est à base d'une toile de fil de métal élastique conductrice et résistante chimiquement et thermiquement formée de façon correspondante sans rembourrage en plastique.

20. Procédé selon l'une quelconque des revendications 12 à 19, **caractérisé en ce que** le courant est conduit à l'objet à traiter (6) par l'intermédiaire d'au moins un élément de connexion (8) qui est réalisé de telle sorte qu'il comprend en substance, hormis au niveau des surfaces de contact, une conductivité électrique élevée.

21. Procédé selon l'une quelconque des revendications 12 à 20, **caractérisé en ce que** le courant est conduit à l'objet à traiter (6) par l'intermédiaire de supports de contact (4, 5, 10, 11) comprenant respectivement au moins deux bras porteurs, sachant que l'un des bras porteurs (5,11) d'un support de contact (4, 5, 10, 11) est muni dans la zone de connexion d'une tige (17) et que l'autre bras porteur (4, 10) est muni dans la zone de connexion d'un trou dans lequel la tige (17) pénètre lorsqu'un contact électrique est produit entre les éléments de connexion (8) et l'objet à traiter (6).

22. Procédé selon l'une quelconque des revendications 12 à 21, **caractérisé en ce que** le courant est conduit à l'objet à traiter (6) par l'intermédiaire d'au moins un élément de connexion (8) qui est agencé sur les supports de contact (10, 11), sachant que les supports de contact (10, 11) sont agencés sur les bâtis (14) servant à la fixation de l'objet à traiter (6), sachant en outre qu'au moins un support de contact (10) fixé de manière élastique et au moins un support de contact (11) fixé de manière fixe sont prévus pour la fixation de l'objet à traiter (6) de forme plate et que le support de contact (10) fixé de manière élastique presse l'objet à traiter (6) par l'intermédiaire d'un élément de connexion (8) contre un second élément de connexion (8) au niveau du support de contact fixé de manière fixe (11).
